**Europäisches Patentamt**

**European Patent Office**

**Office européen des brevets**

(19)

(11) Veröffentlichungsnummer: **0 034 321**
**A1**

(12) **EUROPÄISCHE PATENTANMELDUNG**

(21) Anmeldenummer: **81100900.0**

(22) Anmeldetag: **09.02.81**

(51) Int. Cl.³: **H 03 K 5/135**
**H 04 L 11/08**

(30) Priorität: **13.02.80 DE 3005396**

(43) Veröffentlichungstag der Anmeldung:
**26.08.81 Patentblatt 81/34**

(84) Benannte Vertragsstaaten:
**AT BE CH GB LI NL SE**

(71) Anmelder: **SIEMENS AKTIENGESELLSCHAFT Berlin und München**
**Postfach 22 02 61**
**D-8000 München 22(DE)**

(72) Erfinder: **Chaillié, Charles, Ing. grad.**
**Isarweg 2**
**D-8031 Olching(DE)**

(72) Erfinder: **Reisinger, Konrad, Dipl.-Ing.**
**Bahnwiesenweg 5**
**D-8011 Zorneding(DE)**

(54) Schaltungsanordnung zur Gewinnung eines taktgebundenen Signals.

(57) Schaltungsanordnung zur Gewinnung eines taktgebundenen Signals (E), welches Impulse (A1, A2, A3) eines vorgegebenen Signals (A) signalisiert, die während der Taktperioden aufeinanderfolgender Taktimpulse (T) auftreten. Mit Hilfe einer ersten bistabilen Kippstufe (K1) wird ein Ausgangssignal (C) erzeugt, das immer dann einen ersten Binärwert annimmt, wenn ein Impuls des vorgegebenen Signals (A) auftritt und das einen zweiten Binärwert annimmt, wenn während einem Taktimpuls (T) kein Impuls des vorgegebenen Signals auftritt. Das Ausgangssignal (C) und die Taktimpulse (T) werden einer zweiten Kippstufe (K2) zugeführt, die über einen Ausgang das taktgebundene Signal (E) abgibt, das die mit den Taktimpulsen koinzidierenden Binärwerte des Ausgangssignals (C) signalisiert.

FIG1

EP 0 034 321 A1

COMPLETE DOCUMENT

SIEMENS AKTIENGESELLSCHAFT    Unser Zeichen
Berlin und München           VPA 80 P 2 3 1 3 E

Schaltungsanordnung zur Gewinnung eines taktgebundenen
Signals.

Die Erfindung bezieht sich auf eine Schaltungsanordnung
zur Gewinnung eines taktgebundenen Signals, welches Impulse eines vorgegebenen Signals signalisiert, die während
der Taktperioden aufeinanderfolgender Taktimpulse auftreten.

Bei der Auswertung einer vorgegebenen Impulsfolge kann es
zweckmäßig sein, festzustellen, ob mindestens einer dieser
Impulse während der Taktperiode aufeinanderfolgender Taktimpulse auftritt. Wenn beispielsweise mit der vorgegebenen
Impulsfolge der Datenverkehr auf einer Leitung signalisiert wird, dann kann es wünschenswert sein, zu ermitteln,
ob während der einzelnen Taktperioden mit mindestens einem
beliebig kurzen Impuls ein Datenverkehr auf der betreffenden Leitung angezeigt wird. Gemäß einem internen Stand der
Technik könnte die vorgegebene Impulsfolge einer monostabilen Schaltstufe zugeführt werden, über deren Ausgang unter diesen Voraussetzungen rechteckförmige Impulse abgegeben werden, deren Impulsdauer mindestens gleich der Dauer
des quasistabilen Zustandes der monostabilen Schaltstufe
ist. Diese monostabile Schaltstufe würde zwar auch extrem
kurze vorgegebene Impulse durch verhältnismäßig breite
Rechteckimpulse signalisieren, hätte aber den Nachteil,
daß die Impulsflanken der erzeugten Rechteckimpulse zu beliebigen Zeitpunkten auftreten und nicht im Rahmen eines
Taktrasters liegen. Die Verwendung einer monostabilen
Schaltstufe hätte aber noch den weiteren Nachteil, daß die
Impulsbreiten der erzeugten Rechteckimpulse von einzelnen
Bauteilen der monostabilen Schaltstufe abhängig wären.

Wdb 1 Ram /7.2.80

In vielen Fällen ist nicht nur eine einzige Impulsfolge vorgegeben, sondern es ist eine größere Anzahl derartiger Impulsfolgen vorgegeben, die untersucht werden müssen, ob sie während aufeinanderfolgender Taktperioden Impulse enthalten. Unter diesen Voraussetzungen müßte für jede der zu untersuchenden Impulsfolgen je eine monostabile Schaltungsanordnung vorgesehen sein. Die Genauigkeit, mit der diese monostabilen Schaltstufen arbeiten würden, wäre aber von einzelnen Bauteilen dieser monostabilen Schaltstufen abhängig, so daß bei den gegebenen Bauteiltoleranzen mit verschiedenen Genauigkeiten zu rechnen wäre.

Der Erfindung liegt die Aufgabe zugrunde, eine Schaltungsanordnung anzugeben, mit Hilfe der während einer Taktperiode auftretende Impulse eines vorgegebenen Signals derart signalisiert werden, daß sich Bauteiltoleranzen monostabiler Schaltstufen nicht nachteilig auf die Genauigkeit des zu erzeugenden taktgebundenen Signals auswirken.

Die der Erfindung zugrundeliegende Aufgabe wird dadurch gelöst, daß die Taktimpulse und die Impulse des vorgegebenen Signals einer ersten Kippstufe zugeführt werden, dessen Ausgangssignal immer dann einen ersten Binärwert annimmt, wenn ein Impuls des vorgegebenen Signals auftritt und das einen zweiten Binärwert annimmt, wenn während einem Taktimpuls kein Impuls des vorgegebenen Signals auftritt, daß das Ausgangssignal und die Taktimpulse einer zweiten Kippstufe zugeführt werden, die über einen Ausgang das taktgebundene Signal abgibt, das die mit den Taktimpulsen koinzidierenden Binärwerte des Ausgangssignals signalisiert.

Die erfindungsgemäße Schaltungsanordnung zeichnet sich dadurch aus, daß die Binärwerte des taktgebundenen Signals nicht von Bauteilen einer monostabilen Schaltstufe abhängen, weil keine monostabile Schaltstufe zur Erzeugung des taktgebundenen Signals verwendet wird. Die Genauigkeit, mit der die einzelnen Impulsflanken des vorgegebenen Signals erfaßt werden, ist von den Taktimpulsen abhängig. Falls die Impulse mehrerer vorgegebener Signale signalisiert werden sollen, dann werden die entsprechenden taktgebundenen Signale mit gleicher Genauigkeit erzeugt, weil in allen Fällen die gleichen Taktimpulse verwendet wurden.

Ein besonders bewährtes Ausführungsbeispiel ist dadurch gekennzeichnet, daß als erste Kippstufe ein erstes D-Flipflop vorgesehen ist, mit einem Eingang, einem Takteingang, einem Rücksetzeingang und mit einem Ausgang, daß dem Eingang ein Signal zugeführt wird, das einen konstanten Binärwert signalisiert, daß dem Takteingang die Taktimpulse zugeführt werden, daß dem Rücksetzeingang das vorgegebene Signal zugeführt wird, daß über den Ausgang das Ausgangssignal abgegeben wird, daß als zweite Kippstufe ein zweites D-Flipflop vorgesehen ist, daß einem Eingang des zweiten D-Flipflops das Ausgangssignal und einem Takteingang des zweiten D-Flipflops die Taktimpulse zugeführt werden und daß über einen Ausgang des zweiten D-Flipflops das taktgebundene Signal abgegeben wird.

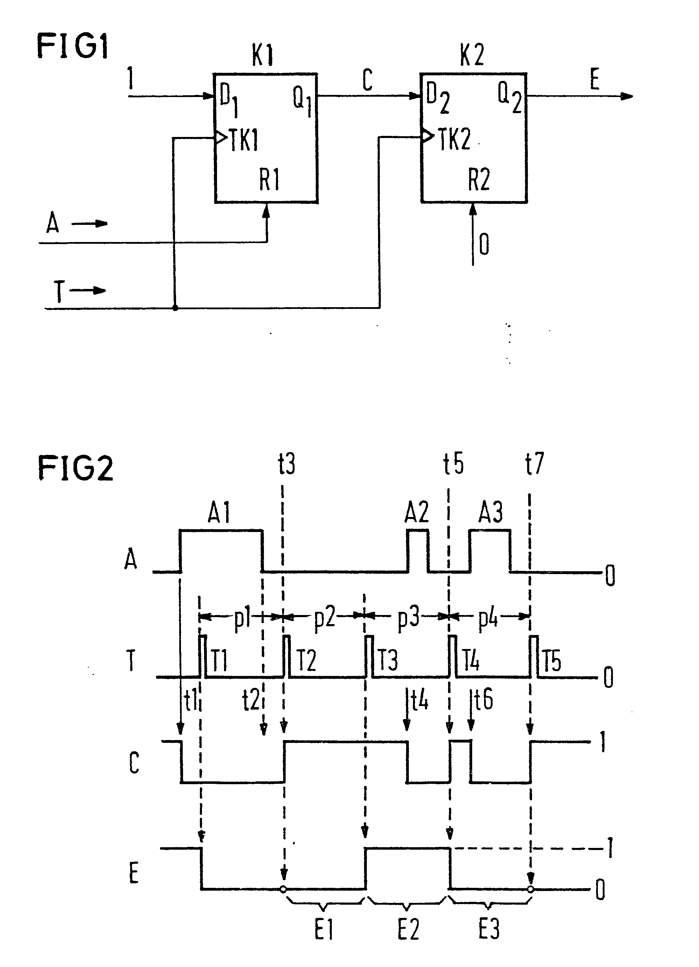

Im folgenden werden Ausführungsbeispiele der Erfindung anhand der Figuren 1 und 2 beschrieben.

Es zeigen:

Fig. 1 eine auf Impulse eines vorgegebenen Signals ansprechende Schaltungsanordnung und

Fig. 2 Impulsfolgen, die im Bereich der in Fig. 1 dargestellten Schaltungsanordnung auftreten.

Die in Fig. 1 dargestellte Schaltungsanordnung besteht im wesentlichen aus den beiden bistabilen Schaltstufen K1 und K2. Beispielsweise können derartige bistabile Schaltstufen durch D-Flipflops realisiert werden. Die Schaltstufen K1 bzw. K2 besitzen je einen Eingang D1 bzw. D2, je einen Takteingang TK1 bzw. TK2, je einen Rücksetzeingang R1 bzw. R2 und je einen Ausgang Q1 bzw. Q2. Die beiden stabilen Zustände dieser Kippstufe werden als O-Zustand bzw. als 1-Zustand bezeichnet, während dem sie über ihren Ausgang ein
O-Signal bzw. ein 1-Signal abgeben. Wenn sich die Kippstufe
K1 in ihrem 1-Zustand befindet, dann wird sie mit einem
1-Signal am Rücksetzeingang R1 in ihren O-Zustand zurückgesetzt, wobei die Binärwerte der an den Eingängen D1 und
TK1 anliegenden Signale keine Rolle spielen. Falls die Kippstufe K1 bereits in ihrem O-Zustand ist, dann wird dieser
Zustand durch ein 1-Signal am Rücksetzeingang R1 nicht verändert.

Wenn am Rücksetzeingang ein O-Signal anliegt und am Takteingang eine positive Impulsflanke auftritt, dann wird der
am Eingang D1 bzw. D2 anliegende Binärwert über den Ausgang Q1 bzw. Q2 abgegeben. Am Eingang D1 der Kippstufe K1
liegt dauernd ein 1-Signal an, so daß bei einem O-Signal
am Rücksetzeingang R1 und bei einer positiven Impulsflanke
am Takteingang TK1 immer ein 1-Signal über den Ausgang Q1
abgegeben wird. Am Rücksetzeingang R2 der Kippstufe K2
liegt dauernd ein O-Signal an.

Fig. 2 zeigt einige Signale, die im Bereich der in Fig.
1 dargestellten Schaltungsanordnung auftreten. Das Signal
A ist vorgegeben und wird aus den Impulsen A1, A2, A3 gebildet. Die Impulse A1 bis A3 treten zu beliebigen Zeitpunkten auf, wobei deren Dauer sehr unterschiedlich sein
kann. Die in Fig. 1 dargestellte Schaltungsanordnung hat
die Aufgabe, das taktgebundene Signal E zu erzeugen, das
das Auftreten der Impulse A1, A2, A3 in taktgebundener
Weise signalisiert. Dabei soll es nur darauf ankommen, ob
während der Taktimpulse p1 bis p4 einer der Impulse A1,
A2, A3 auftritt oder nicht. Die Dauer dieser Impulse A1,
A2, A3 soll dabei keine Rolle spielen.

Ab dem Zeitpunkt t1 bis zum Zeitpunkt t2 liegt ein 1-Signal
am Rücksetzeingang R1, so daß über den Ausgang q1 das Signal C=O abgegeben wird. Zum Zeitpunkt t3 erscheint eine

positive Impulsflanke des Taktsignals T und mit dem Signal
A=0 wird das 1-Signal vom Eingang D1 übernommen und das
Signal C=1 abgegeben. Zum Zeitpunkt t4 entsteht ähnlich
wie zum Zeitpunkt t1 eine Flanke des Signals C. Zum Zeitpunkt t5 entsteht ähnlich wie zum Zeitpunkt t3 eine positive Impulsflanke des Signals C. Zu den Zeitpunkten t6
bzw. t7 wiederholen sich die Vorgänge zu den Zeitpunkten
t4 bzw. t5. Das Signal C nimmt also immer dann einen 0-Wert
an, wenn einer der Impulse A1, A2, A3 des vorgegebenen Signals A auftritt und nimmt immer dann einen 1-Wert an, wenn
während einem der Taktimpulse des Taktsignals T kein Impuls
des vorgegebenen Signals auftritt.

Das Signal C liegt am Eingang D2 der Kippstufe K2. Da am
Rücksetzeingang R2 dauernd ein 0-Signal anliegt, werden
beim Auftreten einer positiven Flanke des Taktsignals T
immer die jeweiligen Binärwerte des Signals C in das Signal
E übernommen. Der Taktimpuls T1 und der 0-Wert des Signals
C bewirken den entsprechenden 0-Wert des Signals E. Der
Taktimpuls T2 koinzidiert noch mit einem 0-Wert des Signals
C, so daß dieser 0-Wert in das Signal E übernommen wird.
Mit dem Taktimpuls T3 wird der 1-Wert des Signals C in das
Signal E übernommen. Der Taktimpuls T4 koinzidiert noch
mit einem 0-Wert des Signals C, so daß dieser 0-Wert in
das Signal E übernommen wird. Ähnlich ist es im Fall des
Taktimpulses T5. Das Signal E signalisiert somit jene Binärwerte des Signals C, die mit den Taktimpulsen T1 bis
T5 koinzidieren.

Das Signal E zeichnet sich einmal dadurch aus, daß es taktgebunden ist, weil seine Binärwertwechsel mit Taktimpulsen
koinzidieren. Dabei signalisieren 0-Werte des Signals E
entsprechende Impulse des Signals A und 1-Werte des Signals
E signalisieren das Fehlen derartiger Impulse des vorgegebenen Signals A. Insbesondere signalisiert der Signalteil E1, daß während der Taktperiode p1 der Impuls A1 aufgetreten ist. Der Signalteil E2 signalisiert, daß während

**0034321**

**80 P 2313 E**

der Periodendauer p2 kein Impuls des vorgegebenen Signals A aufgetreten ist und der Signalteil E3 signalisiert, daß während der Periodendauer p3 der Impuls A2 des vorgegebenen Signals A aufgetreten ist.

In den meisten Fällen ist damit zu rechnen, daß mehrere Signale nach Art des Signals A vorgegeben sind. Es ist dann für alle diese Signale je eine Schaltungsanordnung gemäß Fig. 1 vorgesehen und es wird in prinzipiell gleicher Weise je ein taktgebundenes Signal erzeugt, das dem Signal E entspricht. Die Genauigkeit derartiger taktgebundener Signale ist in allen Fällen gleich und hängt im wesentlichen von den Taktimpulsen T ab.

2 Patentansprüche

2 Figuren

Patentansprüche

1. Schaltungsanordnung zur Gewinnung eines taktgebundenen Signals, welches Impulse eines vorgegebenen Signals signalisiert, die während der Taktperioden aufeinanderfolgender Taktimpulse auftreten, d a d u r c h   g e k e n n - z e i c h n e t ,  daß die Taktimpulse (T) und die Impulse des vorgegebenen Signals (A) einer ersten Kippstufe (K1) zugeführt werden, dessen Ausgangssignal (C) immer dann einen ersten Binärwert (0) annimmt, wenn ein Impuls (A1, A2, A3) des vorgegebenen Signals (A) auftritt und das einen zweiten Binärwert (1) annimmt, wenn während einem Taktimpuls (T) kein Impuls des vorgegebenen Signals (A) auftritt, daß das Ausgangssignal (C) und die Taktimpulse (T) einer zweiten Kippstufe (K2) zugeführt werden, die über einen Ausgang das taktgebundene Signal (E) abgibt, das die mit den Taktimpulsen (T) koinzidierenden Binärwerte des Ausgangssignals (C) signalisiert (Fig. 1 und 2).

2. Schaltungsanordnung nach Anspruch 1, d a d u r c h   g e k e n n z e i c h n e t ,  daß als erste Kippstufe (K1) ein erstes D-Flipflop vorgesehen ist, mit einem Eingang (D1), einem Takteingang (T1), einem Rücksetzeingang (R1) und mit einem Ausgang (Q1), daß dem Eingang (D1) ein Signal zugeführt wird, das einen konstanten Binärwert (1) signalisiert, daß dem Takteingang (T1) die Taktimpulse (T) zugeführt werden, daß dem Rücksetzeingang (R1) das vorgegebene Signal (A) zugeführt wird, daß über den Ausgang (Q1) das Ausgangssignal (C) abgegeben wird, daß als zweite Kippstufe (K2) ein zweites D-Flipflop vorgesehen ist, daß einem Eingang (D2) des zweiten D-Flipflops das Ausgangssignal (C) und einem Takteingang (T2) des zweiten D-Flipflops die Taktimpulse (T) zugeführt werden und daß über einen Ausgang des zweiten D-Flipflops das taktgebundene Signal (E) abgegeben wird (Fig. 1 und 2).

0034321

1/1

FIG1

FIG2

0034321

Europäisches
Patentamt

**EUROPÄISCHER RECHERCHENBERICHT**

Nummer der Anmeldung

EP 81100900.0

| | EINSCHLÄGIGE DOKUMENTE | | KLASSIFIKATION DER ANMELDUNG (Int. Cl.³) |
|---|---|---|---|
| Kategorie | Kennzeichnung des Dokuments mit Angabe, soweit erforderlich, der maßgeblichen Teile | betrifft Anspruch | |
| | DE - A - 2 246 590 (PHILIPS)<br><br>+ Seite 1, Zeile 1 - Seite 2, Zeile 20; Seite 3, Zeile 9- Seite 4, Zeile 23; Fig. 1,2 +<br><br>--<br><br>DE - A - 2 224 391 (SIEMENS)<br><br>+ Seite 1, Zeilen 1-12; Seite 2, Zeile 2 - Seite 3, Zeile 18; Seite 4, Zeilen 17-30; Fig. 1-3 +<br><br>---- | 1<br><br><br><br><br>1 | H 03 K 5/135<br>H 04 L 11/08 |

RECHERCHIERTE SACHGEBIETE (Int. Cl.³)

H 03 K 5/00

H 03 K 3/00

H 03 K 13/00

H 04 L 11/00

H 04 L 7/00

H 04 L 25/00

H 04 L 3/00

KATEGORIE DER GENANNTEN DOKUMENTE

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

| X | Der vorliegende Recherchenbericht wurde für alle Patentansprüche erstellt. |
|---|---|

| Recherchenort | Abschlußdatum der Recherche | Prüfer |
|---|---|---|
| WIEN | 20-05-1981 | HAJOS |

EPA form 1503.1  06.78